# EUROPEAN PATENT APPLICATION

(11) **EP 4 084 046 A1**
(43) Date of publication of application: **02.11.2022**
(21) Application number: 19957165.4
(22) Date of filing: 26.12.2019
(51) Int. Cl.: H01L 21/52, H05K 13/04

(54) **COMPONENT MOUNTING MACHINE AND TRANSFER MATERIAL TRANSFER METHOD**

(71) Applicant: Fuji Corporation, Chiryu-shi, Aichi 472-8686 (JP)
(72) Inventor: ICHINO, Shinji, Chiryu-shi, Aichi 472-8686 (JP); IWAKI, Noriaki, Chiryu-shi, Aichi 472-8686 (JP); HAMANE, Tsuyoshi, Chiryu-shi, Aichi 472-8686 (JP)
(74) Representative: Grünecker Patent- und Rechtsanwälte PartG mbB
(86) International application number: PCT/JP2019/051197
(87) International publication number: WO 2021/130975

(57) **Abstract**

Transfer material supply units (13 and 14) for supplying a transfer material to a transfer table (80) and spreading the transfer material in a film shape on the transfer table is set in a free space of a feeder setting section (12) of a component mounting machine (10), and transfer pins (24 and 25) for transferring the transfer material on the transfer table to a mounting surface (15a) of a three-dimensional board (15) are held by at least one mounting head of the component mounting machine to be exchangeable with a suction nozzle (23) for picking up a circuit component. The lower end of the transfer pin is immersed in the transfer material on the transfer table to attach the transfer material to the lower end of the transfer pin by moving the mounting head holding the transfer pin to a position above the transfer table to lower and raise the transfer pin, and then the transfer material attached to the lower end of the transfer pin is transferred to the mounting surface of the three-dimensional board by moving the mounting head above the mounting surface of the three-dimensional board to lower and raise the transfer pin.

## Description

### Technical Field

The present specification discloses a component mounting machine for mounting a circuit component on a mounting surface of a three-dimensional board formed in a three-dimensional shape, and a technique relating to a transfer material transfer method for transferring a transfer material to the mounting surface of the three-dimensional board.

### Background Art

In recent years, as a three-dimensional board formed in a three-dimensional shape, a molded interconnect device (MID), which is a three-dimensional resin molded article on which a mounting surface and a wiring pattern are formed, has attracted attention as a mounting technique for realizing downsizing, reducing the number of components, reducing the number of assembling steps, and the like of electronic devices. This MID mounting technique is proposed, for example, in Patent Literature 1 (International Publication No. WO2018/163323). In the step of mounting a circuit component such as a semiconductor component on the mounting surface of the MID, similarly to the step of mounting a circuit component on a general flat board, cream-shaped solder is applied to an electrode on the mounting surface of the MID, and then the circuit component is mounted on the mounting surface. In this MID, since multiple mounting surfaces having different heights are formed, or the mounting surface is formed in a shape inclined with respect to a horizontal plane, solder cannot be printed on the mounting surface by a screen printing method as in a general flat board. Therefore, in Patent Literature 1, a dispense head (application head) provided with an elongated dispense nozzle (application nozzle) is mounted on a component mounting machine for a mounting circuit component on a mounting surface of an MID such that solder is discharged by the dispense nozzle and is applied to a mounting surface of the MID.

### Patent Literature

Patent Literature 1: International Publication No. WO 2018/163323

### Summary of the Invention

### Technical Problem

In order to enable the dispense nozzle to apply the solder to the mounting surface of the MID having various three-dimensional shapes, it is necessary to elongate the dispense nozzle so that the dispense head does not interfere with the MID having various three-dimensional shapes during a solder applying operation. However, since the inner diameter of the dispense nozzle is very thin in order to apply solder to fine electrodes or the like on the mounting surface, in a case where a transfer material having a high viscosity such as solder is applied, if the dispense nozzle is elongated, the transfer material is likely to be clogged in the dispense nozzle, making stable application difficult.

### Solution to Problem

In order to solve the above-mentioned problems, there is provided a component mounting machine for mounting a circuit component on a mounting surface of a three-dimensional board formed in a three-dimensional shape, the machine including a transfer material supply unit configured to supply a transfer material on a transfer table and spread the transfer material in a film shape on the transfer table, a transfer pin for transferring the transfer material on the transfer table to the mounting surface of the three-dimensional board, a moving device configured to move the transfer pin, and a control device configured to control an operation of the moving device, in which the control device controls the operation of the moving device to control an operation of immersing a lower end of the transfer pin in the transfer material on the transfer table, attaching the transfer material to the lower end of the transfer pin, and transferring the transfer material to the mounting surface of the three-dimensional board.

In this configuration, since the transfer material is transferred by the transfer pin to the mounting surface of the three-dimensional board by using the component mounting machine for mounting the circuit component on the mounting surface of the three-dimensional board, the transfer material can be stably transferred to the mounting surface of the three-dimensional board having various three-dimensional shapes even if the transfer pin is elongated so that the head holding the transfer pin does not interfere with the three-dimensional board having various three-dimensional shapes during a transfer material transfer operation.

### Brief Description of Drawings

Fig. 1 is a plan view illustrating a configuration of a principal portion of a component mounting machine according to an embodiment.
Fig. 2 is a block diagram illustrating a control system configuration of the component mounting machine.
Fig. 3 is a perspective view illustrating a state in which a transfer pin and a suction nozzle are detached from a mounting head.
Fig. 4 is a perspective view illustrating a state in which the transfer pin and the suction nozzle are attached to the mounting head.
Fig. 5 is an enlarged perspective view of the transfer pin.
Fig. 6 is a side view partially cut illustrating a configuration of a transfer material supply unit set in the component mounting machine.
Fig. 7 is a plan view of the transfer material supply unit.
Fig. 8 is a side view illustrating a state of a three-dimensional board during conveying.
Fig. 9 is a side view illustrating a tilting state of the three-dimensional board during a transfer material transfer operation.

### Description of Embodiments

Hereinafter, an embodiment disclosed in the present specification will be described. First, a configuration of entire component mounting machine 10 will be described.

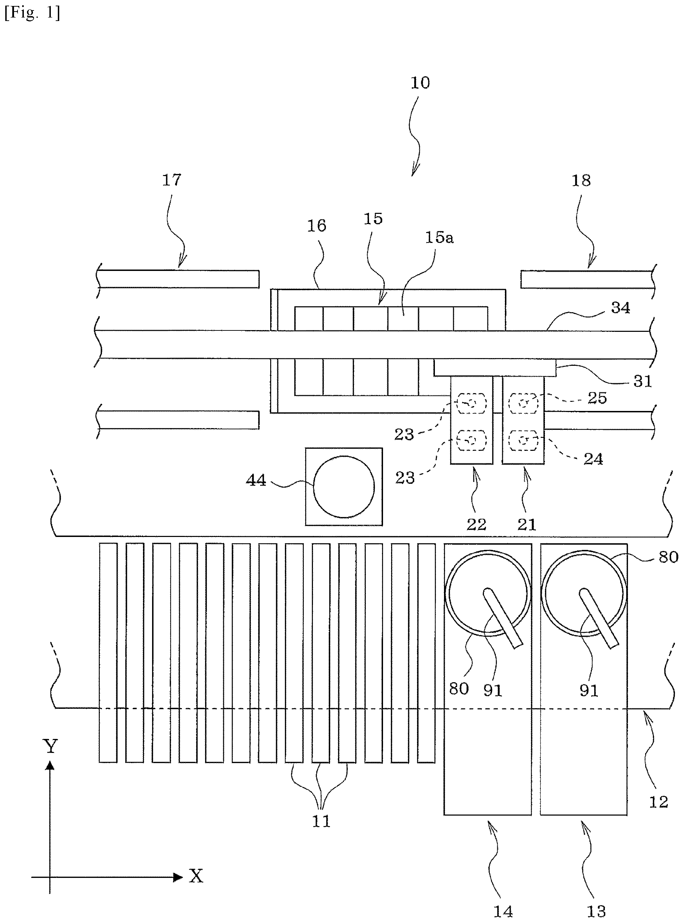

As illustrated in Fig. 1, feeder setting section 12 for setting multiple feeders 11 such as a tape feeder and a tray feeder for supplying circuit components to be exchangeable (detachable) is provided on the front surface side (lower side in Fig. 1) of component mounting machine 10, and multiple transfer material supply units 13 and 14 for separately supplying multiple types of transfer materials for each type are set to be exchangeable (detachable) in a free space of feeder setting section 12. In the present embodiment, two transfer material supply units 13 and 14 for separately supplying two types of transfer materials (flowable solder and adhesive) are set in the free space of feeder setting section 12.

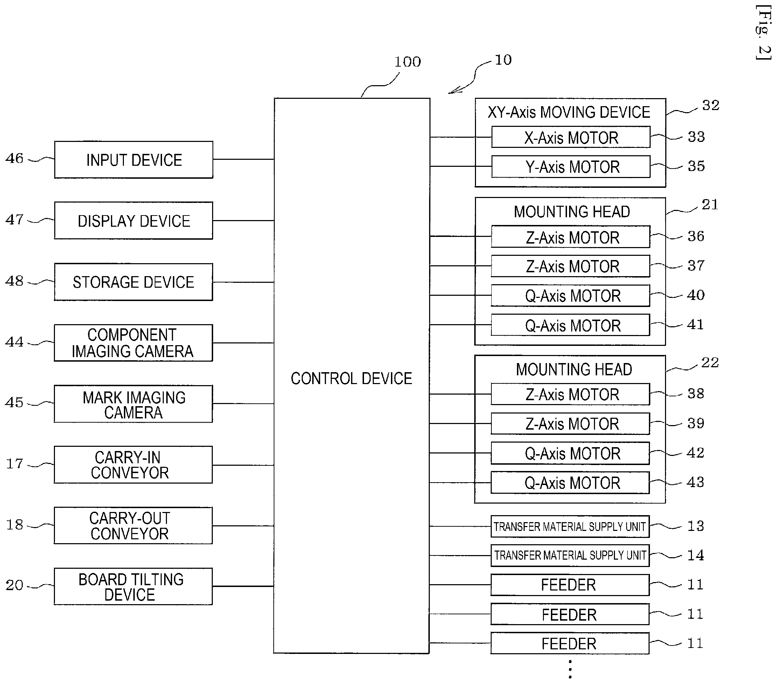

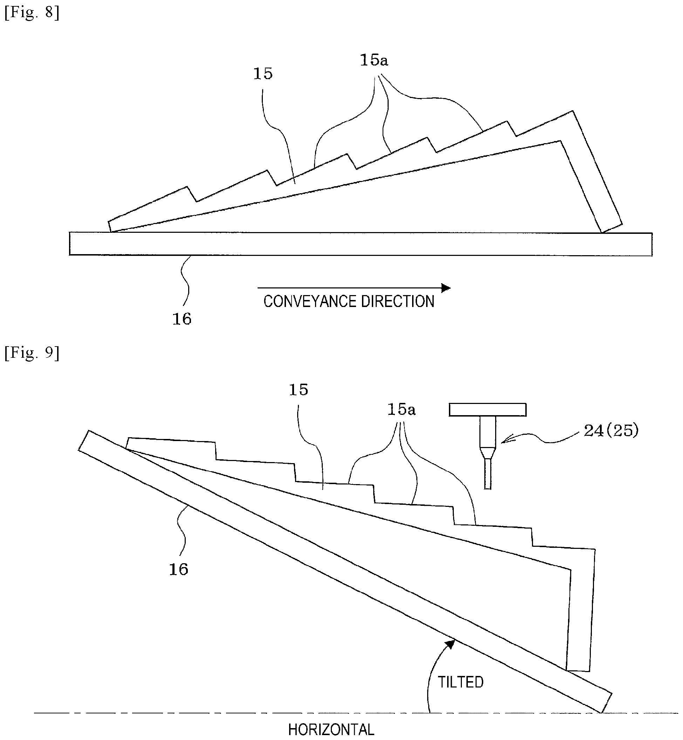

As illustrated in Fig. 9, in component mounting machine 10, conveyors 17 and 18 are provided to carry in and out three-dimensional board 15 such as an MID in an X direction (right direction of Fig. 1) in a state of holding three-dimensional board 15 on conveyance pallet 16, and as illustrated in Fig. 9, between carry-in conveyor 17 and carry-out conveyor 18, there is provided board tilting device 20 (see Fig. 2) for tilting and holding three-dimensional board 15 on conveyance pallet 16 until mounting surface 15a becomes horizontal during a transfer material transfer operation and a component mounting operation. Board tilting device 20 is configured by, for example, an articulated robot (not illustrated) such that conveyance pallet 16 is held with a holder (not illustrated) at a distal end of the arm to tilt conveyance pallet 16 integrally with three-dimensional board 15.

The insulating portion of three-dimensional board 15 is molded into a three-dimensional shape having inclined surfaces by injection molding, mold molding, or the like of an insulating resin, and, for example, multiple mounting surfaces 15a having different heights are formed on the surface side thereof in a shape inclined with respect to the horizontal plane, as illustrated in Fig. 8. A wiring pattern (not illustrated) is formed on three-dimensional board 15 by a wiring pattern forming technique, and further electrodes (pads, lands, and the like) coupled to the wiring pattern are formed at positions of mounting surfaces 15a at which terminals (bumps, leads, and the like) of circuit components are reflow-soldered. The circuit components to be mounted on each mounting surface 15a are, for example, various circuit components such as a semiconductor component, a capacitor, a resistor, and a connector.

In component mounting machine 10, for example, two mounting heads 21 and 22, which are multiple mounting heads for mounting a circuit component on mounting surface 15a of three-dimensional board 15, are mounted. Two mounting heads 21 and 22 have the same configuration, and are configured so that any of suction nozzle 23 for picking up a circuit component and transfer pins 24 and 25 for transferring a transfer material to mounting surface 15a of three-dimensional board 15 can be sucked and held to be exchangeable (detachable), as described later.

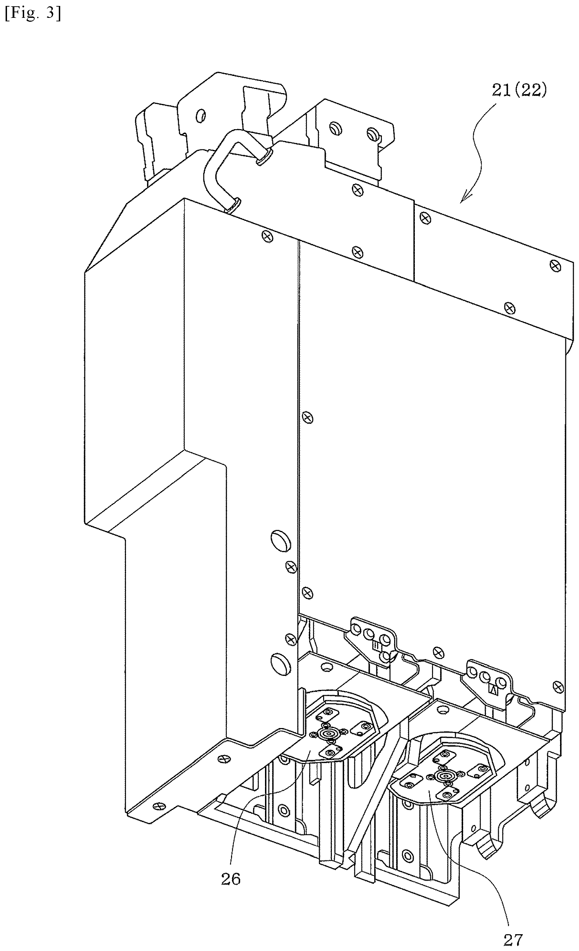

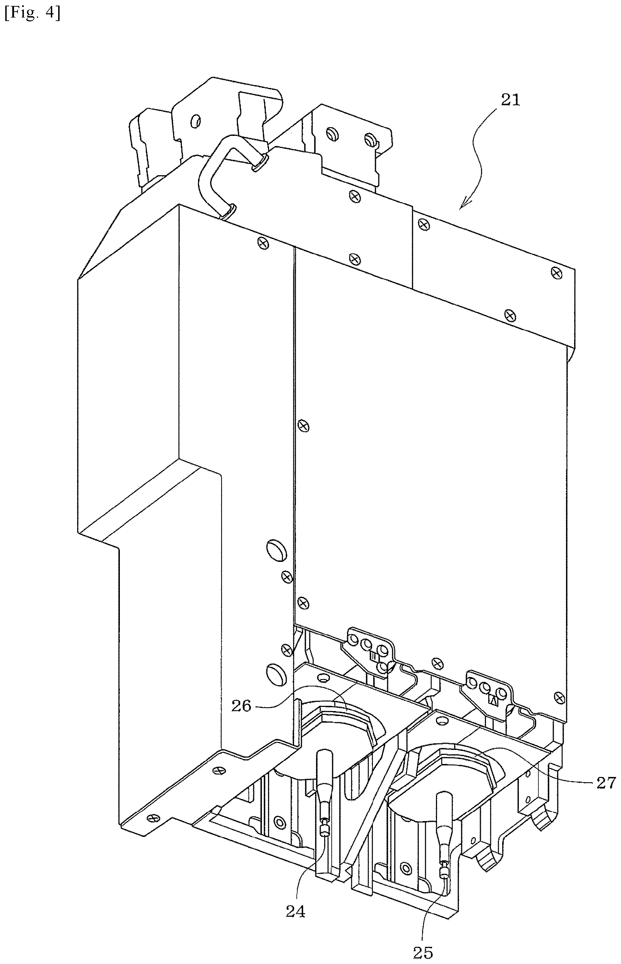

As illustrated in Figs. 3 and 4, in each of mounting heads 21 and 22, two suction and holding sections 26 and 27 are provided respectively, and each of suction and holding sections 26 and 27 has a configuration in which any of suction nozzle 23 and transfer pins 24 and 25 can be sucked and held to be exchangeable. In the present embodiment, one mounting head 21 is used for the transfer operation of a transfer material, and the other mounting head 22 is used for the mounting operation of a circuit component. Accordingly, transfer pins 24 and 25 are sucked and held by suction and holding sections 26 and 27 of mounting head 21 for transferring a transfer material, respectively, and suction nozzles 23 are sucked and held by suction and holding sections 26 and 27 of mounting head 22 for mounting a component, respectively.

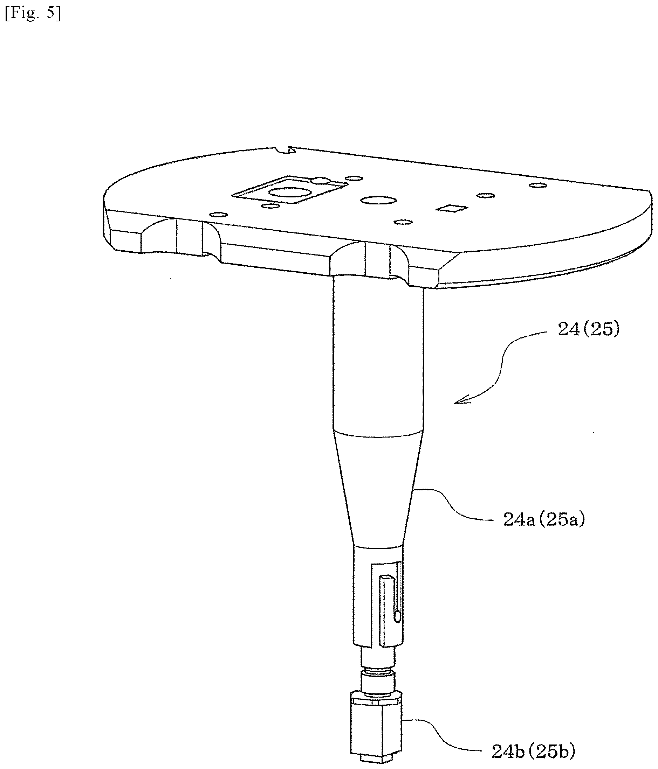

As illustrated in Fig. 5, each of transfer pins 24 and 25 has a configuration in which pin distal end sections 24b and 25b are attached to the lower end portions of pin main body sections 24a and 25a to be exchangeable by engagement, screwing, or the like. The upper end coupling portions of pin main body sections 24a and 25a are formed in the same shape as the upper end coupling portion of suction nozzle 23 so that the coupling structure with respect to suction and holding sections 26 and 27 of mounting heads 21 and 22 are shared. In the present embodiment, multiple types of pin distal end sections 24b and 25b having different shapes are prepared so that pin distal end sections 24b and 25b having any shape can be attached to the lower end portions of pin main body sections 24a and 25a to be exchangeable by engagement, screwing, or the like.

It is needless to say that a transfer pin in which the pin main body section and the pin distal end section are integrated and the pin distal end section cannot be exchanged may be used. In addition, the shape of the pin distal end section is not limited to the shape for transferring a transfer material to one location, but may be a shape for simultaneously transferring a transfer material to multiple locations.

As illustrated in Fig. 1, two mounting heads 21 and 22 are attached to X-axis slide 31, and are integrally moved in an XY-direction by XY-axis moving device 32 (see Fig. 2). X-axis slide 31 moves in the X direction along X axis 34 by using X-axis motor 33 (see Fig. 2) including a servo motor, a linear motor, and the like as a driving source. Both ends of X axis 34 are supported to move in a Y direction with respect to a Y axis (not illustrated) orthogonal to X axis 34. X axis 34 moves in the Y direction along the Y axis by using Y-axis motor 35 (see Fig. 2) including a servo motor, a linear motor, and the like as a driving source.

Two mounting heads 21 and 22 have the same configuration, and as illustrated in Fig. 2, each mounting head 21 (22) is provided with two Z-axis motors 36 and 37 (38 and 39) for vertically moving two transfer pins 24 and 25 (two suction nozzles 23) individually, and two Q-axis motors 40 and 41 (42 and 43) for individually rotating two transfer pins 24 and 25 (two suction nozzles 23). In the present embodiment, a moving device for moving transfer pins 24 and 25 (suction nozzle 23) in an XYZ direction is configured from XY-axis moving device 32 and Z-axis motors 36 and 37 (38 and 39), and the like.

On the other hand, in component mounting machine 10, component imaging camera 44 for capturing an image of a circuit component picked up by suction nozzle 23 of mounting head 22 from the lower side thereof to image and recognize the suction posture or the like of the circuit component is provided upward, and mark imaging camera 45 for capturing an image of a reference mark or the like of three-dimensional board 15 from the upper side thereof to recognize the reference position or the like of three-dimensional board 15 is provided to move integrally with mounting heads 21 and 22 in the XY-direction.

Although not illustrated, in component mounting machine 10, there are provided a transfer pin storage section and a suction nozzle storage section for storing a transfer pin for exchange and a suction nozzle for exchange for exchanging transfer pins 24 and 25 and suction nozzle 23 held by respective mounting heads 21 and 22, and transfer pins 24 and 25 and suction nozzle 23 held by mounting heads 21 and 22 are automatically exchangeable with a transfer pin for exchange and a suction nozzle for exchange.

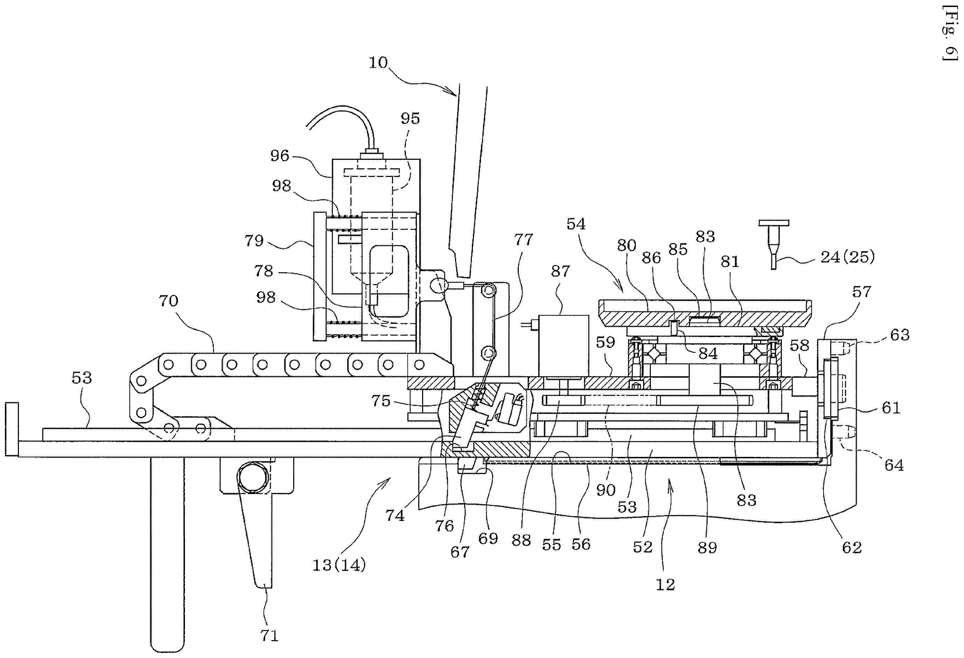

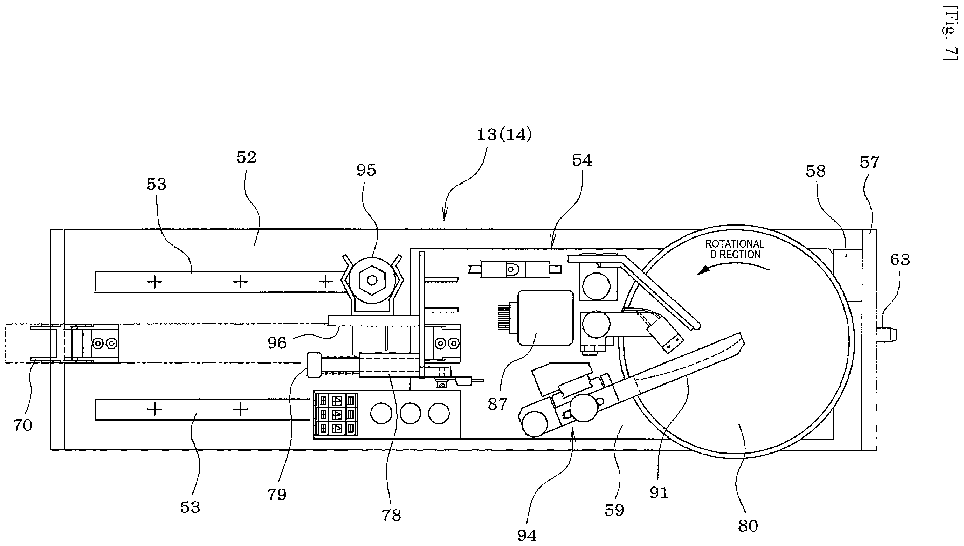

Next, the configurations of two transfer material supply units 13 and 14 will be described with reference to Figs. 6 and 7. Two transfer material supply units 13 and 14 have the same configuration except that the types of transfer materials to be supplied are different from each other. Each transfer material supply unit 13 (14) includes attachment base 52 to be mounted on feeder setting section 12 of component mounting machine 10, and transfer material supply device main body 54 mounted on attachment base 52, and transfer material supply device main body 54 is configured to slide and move between an inner set position (position in Fig. 6) and an outer draw-out position of component mounting machine 10 along two guide rails 53 provided on the upper surface of attachment base 52.

The attachment structure of transfer material supply unit 13 (14) with respect to feeder setting section 12 of component mounting machine 10 is shared with the attachment structure of feeder 11. Specifically, mounting guide groove 55 extending in the attaching/detaching direction of transfer material supply unit 13 (14) is formed in feeder setting section 12 of component mounting machine 10, and protrusion 56 provided on the lower surface of attachment base 52 of transfer material supply unit 13 (14) is placed in a state of being fitted into mounting guide groove 55.

Rising plate 57 is vertically erected on the distal end portion (forward end portion) of attachment base 52, stopper 58 for transfer material supply device main body 54 is provided on rising plate 57, and when an operator pushes transfer material supply device main body 54 into the set position inside component mounting machine 10, base plate 59 of transfer material supply device main body 54 abuts on stopper 58 so that transfer material supply device main body 54 is stopped at the set position.

Rising plate 57 of attachment base 52 is provided with connector 62 for connecting the signal line and the power supply line of transfer material supply unit 13 (14) to connector 61 on the side of feeder setting section 12, and engaging pins 63 and 64 for engaging and fixing attachment base 52 to the side of feeder setting section 12, and attachment base 52 is engaged and fixed to the side of feeder setting section 12 by inserting engaging pins 63 and 64 into engagement holes in the back wall portion of feeder setting section 12. Lock member 67 is attached to attachment base 52 so as to be vertically movable in a state where lock member 67 is biased downward by a spring or the like.

In a case where attachment base 52 is set in feeder setting section 12, when attachment base 52 is pushed into feeder setting section 12 until rising plate 57 abuts on the back wall portion of feeder setting section 12, lock member 67 is placed in a state of being fitted into lock hole 69 of feeder setting section 12. As a result, attachment base 52 is locked in a state of being set in feeder setting section 12, engaging pins 63 and 64 of rising plate 57 are inserted into the engagement holes in the back wall portion of feeder setting section 12, and connector 62 on the side of transfer material supply unit 13 (14) is placed in a state of being connected to connector 61 on the side of feeder setting section 12. The signal line and the power supply line of transfer material supply unit 13 (14) are wired to the side of attachment base 52 by cable guide 70 and are connected to connector 62.

Unlocking lever 71 is provided on a portion of attachment base 52 located outside feeder setting section 12, and unlocking lever 71 and lock member 67 are coupled by a wire or the like. Unlocking lever 71 is pivotally biased in a locking direction (counterclockwise direction in Fig. 6) by a torsion coil spring or the like. In a case where transfer material supply unit 13 (14) is detached from feeder setting section 12, unlocking lever 71 is pivoted in the unlocking direction (clockwise direction in Fig. 6) so that lock member 67 can be pulled up from lock hole 69 against the biasing force of a spring or the like to be unlocked.

Next, a configuration of transfer material supply device main body 54 supported to slide and move on attachment base 52 of transfer material supply unit 13 (14) will be described.

First lock member 74 is attached to transfer material supply device main body 54 so as to be vertically movable in a state of being biased downward by spring 75, and first lock member 74 is fitted into one of lock holes 76 (only one location is illustrated) formed at two locations in the front-rear direction of attachment base 52 such that transfer material supply device main body 54 is locked at the inner set position (the position in Fig. 6) and the outer draw-out position of component mounting machine 10.

Unlocking handle 78 is provided to be slidably operable on transfer material supply device main body 54 with respect to handle supporting frame 79, and unlocking handle 78 and first lock member 74 are coupled by wire 77. Unlocking handle 78 is biased by spring 98 in a locking direction (in a direction in which transfer material supply device main body 54 is pushed into the set position). Unlocking handle 78 also serves as a handle that the operator grips when sliding and moving transfer material supply device main body 54, and is disposed to be located outside component mounting machine 10.

When transfer material supply device main body 54 slides and moves between the set position and the draw-out position, unlocking handle 78 is pulled in the unlocking direction (the direction opposite to the locking direction) so that first lock member 74 can be pulled up from lock hole 76 against the biasing force of spring 75 to be unlocked.

Turntable 81 on which dish-shaped transfer table 80 formed of a magnetic material such as an iron-based material is mounted is provided on base plate 59 of transfer material supply device main body 54 such that transfer table 80 is detachably sucked and held by magnets 82 provided on the upper surface of turntable 81. Then, the upper end portion of rotary shaft 83 of turntable 81 protrudes slightly upward from the upper surface of turntable 81, and fitting hole 85 formed in the lower surface center portion of transfer table 80 is fitted into the upper end portion of rotary shaft 83 such that the center of transfer table 80 coincides with the rotational center of turntable 81, and further, anti-rotation hole 86 provided at the eccentric position of the lower surface of transfer table 80 is fitted into anti-rotation pin 84 provided at the eccentric position of the upper surface of turntable 81 in the upward direction so that transfer table 80 is rotationally stopped with respect to turntable 81 to integrally rotate both transfer table 80 and rotary table 81.

Motor 87 serving as a driving source of transfer table 80 is provided on base plate 59 in the downward direction, and belt 90 is stretched between pulley 88 fitted on the rotary shaft of motor 87 and pulley 89 fitted on the lower end portion of rotary shaft 83 of turntable 81. As a result, the rotary force of motor 87 is transmitted to rotary shaft 83 of turntable 81 so that turntable 81 is rotationally driven and transfer table 80 rotates integrally therewith.

Squeegee 91 having a length substantially the same as the radius of transfer table 80 is disposed above transfer table 80 along the radial direction of transfer table 80, and each time the transfer material (solder or adhesive in the present embodiment) is supplied on transfer table 80, transfer table 80 is rotated so that the transfer material on transfer table 80 is uniformly pushed and spread by squeegee 91 to form a film of the transfer material, and then the rotation of transfer table 80 is stopped. In order to be able to adjust the film thickness of the transfer material on transfer table 80, height adjustment mechanism 94 for adjusting the height position of squeegee 91 is provided so that the gap between squeegee 91 and the bottom surface of transfer table 80 can be adjusted by adjusting the height position of squeegee 91 by height adjustment mechanism 94.

Syringe 95 for supplying a transfer material on transfer table 80 is detachably attached to transfer material supply device main body 54 via syringe holding plate 96. Every time the transfer material on transfer table 80 decreases to a level requiring replenishment, the transfer material stored in syringe 95 is discharged and replenished on transfer table 80 by a predetermined amount.

As illustrated in Fig. 2, control device 100 for controlling a transfer material transfer operation and a component mounting operation is provided in component mounting machine 10. Control device 100 is configured by using one or multiple computers (CPUs), and peripheral devices such as input device 46 such as a keyboard, a mouse, and a touch panel, display device 47 such as a liquid crystal display and an organic EL display, and storage device 48 for storing control programs and various data for controlling the operations of respective functions of component mounting machine 10 are connected to control device 100.

As illustrated in Fig. 9, in control device 100 of component mounting machine 10, during the transfer material transfer operation and the component mounting operation, three-dimensional board 15 on conveyance pallet 16 is tilted by board tilting device 20 until mounting surface 15a thereof becomes horizontal, but when three-dimensional board 15 is carried out after the component mounting operation, conveyance pallet 16 is returned to the original horizontal state, conveyed to a reflow furnace (not illustrated), and a circuit component is reflow-soldered to mounting surface 15a of three-dimensional board 15 on conveyance pallet 16. At the time of the solder reflow, as illustrated in Fig. 8, since mounting surface 15a of three-dimensional board 15 on conveyance pallet 16 is placed in a state of being inclined with respect to the horizontal plane, there is a possibility of the slipping and positional deviation of the circuit component by the solder reflowed on inclined mounting surface 15a.

Therefore, in the present embodiment, an adhesive is transferred to mounting surface 15a of three-dimensional board 15 in addition to the solder, and a circuit component is reflow-soldered to mounting surface 15a of three-dimensional board 15 in a state in which the circuit component is bonded to mounting surface 15a of three-dimensional board 15 with the adhesive in the reflow furnace, whereby the circuit component is reflow-soldered while preventing the slipping and positional deviation of the circuit component from inclined mounting surface 15a.

In order to realize this, solder is supplied to transfer table 80 of one transfer material supply unit 13 to form a film of solder, and an adhesive is supplied to transfer table 80 of the other transfer material supply unit 14 to form a film of adhesive. Control device 100 of component mounting machine 10 immerses the lower end of transfer pin 24 in a film of solder on transfer table 80 to attach the solder to the lower end of transfer pin 24 by moving mounting head 21 holding transfer pins 24 and 25 to a position above transfer table 80 of transfer material supply unit 13 for solder transfer to lower and raise one transfer pin 24, and immerses the lower end of transfer pin 25 in a film of the adhesive on transfer table 80 to attach the adhesive to the lower end of transfer pin 24 by moving mounting head 21 to a position above transfer table 80 of transfer material supply unit 14 for adhesive transfer to lower and raise the other transfer pin 25.

Thereafter, control device 100 of component mounting machine 10 transfers the solder attached to the lower end of transfer pin 24 to the electrodes (pads, lands, and the like) on mounting surface 15a of three-dimensional board 15 by moving mounting head 21 holding two transfer pins 24 and 25 to a position above mounting surface 15a of three-dimensional board 15 to lower and raise one transfer pin 24, and transfers the adhesive attached to the lower end of transfer pin 25 to a predetermined position on mounting surface 15a of three-dimensional board 15 by lowering and raising the other transfer pin 25.

Thereafter, control device 100 of component mounting machine 10 picks up the circuit component supplied by the feeder 11 by each suction nozzle 23 by moving mounting head 22 holding two suction nozzles 23 above the component suction position of feeder 11 to lower and raise each suction nozzle 23, and then mounts the circuit component picked up by each suction nozzle 23 on the mounting surface 15a of the three-dimensional board 15 by moving mounting head 22 above the mounting surface 15a of three-dimensional board 15 to lower and raise each suction nozzle 23. As a result, the circuit component is placed in a state of being bonded to mounting surface 15a of three-dimensional board 15 with an adhesive, and the terminals (bumps, leads, and the like) of the circuit component are connected to the electrodes (pads, lands, and the like) of mounting surface 15a with solder. Thereafter, conveyance pallet 16 is returned to the original horizontal state, conveyed to the reflow furnace (not illustrated), and the circuit component is reflow-soldered to mounting surface 15a of three-dimensional board 15 on conveyance pallet 16.

In the present embodiment described above, since component mounting machine 10 for mounting a circuit component on mounting surface 15a of three-dimensional board 15 is used to set transfer material supply units 13 and 14 in the free space of feeder setting section 12 of component mounting machine 10, and transfer pins 24 and 25 are held by one mounting head 21 of two mounting heads 21 and 22 mounted on component mounting machine 10 so that the transfer material is transferred to mounting surface 15a of three-dimensional board 15 with transfer pins 24 and 25, the transfer material can be stably transferred to mounting surface 15a of three-dimensional board 15 having various three-dimensional shapes even if transfer pins 24 and 25 are elongated so that mounting head 21 holding transfer pins 24 and 25 do not interfere with three-dimensional board 15 having various three-dimensional shapes during the transfer material transfer operation.

In addition, in order to transfer two types of transfer materials (in the present embodiment, solder and an adhesive) to mounting surface 15a of three-dimensional board 15, two transfer material supply units 13 and 14 are set in the free space of feeder setting section 12 of component mounting machine 10, and two transfer pins 24 and 25 are held by one mounting head 21 of two mounting heads 21 and 22 of component mounting machine 10, and therefore two types of transfer materials can be individually transferred to mounting surface 15a of three-dimensional board 15 by selectively using two transfer pins 24 and 25 for each type of the transfer materials by using one component mounting machine 10.

In addition, since transfer pins 24 and 25 are held by mounting head 21 of one of two mounting heads 21 and 22 of component mounting machine 10 and suction nozzle 23 is held by the other mounting head 22, a series of steps from the transfer step of the transfer material to mounting surface 15a of three-dimensional board 15 to the mounting step of a circuit component can be performed by one component mounting machine 10.

In the present embodiment, two types of transfer materials are transferred to mounting surface 15a of three-dimensional board 15, but only one type of transfer material or three or more types of transfer materials may be transferred to mounting surface 15a of three-dimensional board 15. In short, the number of transfer material supply units corresponding to the number of types of transfer materials may be set in the free space of feeder setting section 12 of component mounting machine 10, and the number of transfer pins corresponding to the number of types of transfer materials may be held by any of mounting heads 21 and 22 of component mounting machine 10. In addition, one type of transfer material may be transferred by two or more transfer pins, or the number of transfer pins used may be appropriately changed.

In the present embodiment, rotary transfer material supply units 13 and 14 for rotating and squeezing transfer table 80 are used, but a linear transfer material supply unit that fixes the transfer table to linearly move the squeegee in the horizontal direction, or a linear transfer material supply unit that fixes the squeegee to linearly move the transfer table in the horizontal direction may be used.

The transfer material to be transferred to mounting surface 15a of three-dimensional board 15 is not limited to solder and an adhesive, and a conductive paste such as flux and Ag paste may be transferred, for example.

The configuration of mounting heads 21 and 22 may be changed, for example, in a component mounting machine on which a rotary mounting head (rotary head) that holds multiple suction nozzles in a exchangeable way is mounted, a part of the suction nozzles among the multiple suction nozzles held by the rotary mounting head may be exchanged with transfer pins and held. In a configuration in which multiple suction nozzles (multiple transfer pins) are held by one mounting head to be exchangeable, at least one transfer pin and at least one suction nozzle may be mixed and held in one mounting head.

The present invention is not limited to the above-described embodiment, and may be implemented by changing the shape of the three-dimensional board, changing the shape of the transfer pin, or the like in various manners in a range without departing from the gist.

### Reference Signs List

10: component mounting machine, 11: feeder, 12: feeder setting section, 13, 14: transfer material supply unit, 15: three-dimensional board, 15a: mounting surface, 16: conveyance pallet, 17: carry-in conveyor, 18: carry-out conveyor, 20: board tilting device, 21, 22: mounting head, 23: suction nozzle, 24, 25: transfer pin, 26, 27: suction and holding section, 31: X-axis slide, 32: XY-axis moving device (moving device), 34: X axis, 36, 37, 38, 39: Z-axis motor (moving device), 80: transfer table, 91: squeegee, 95: syringe, 100: control device

## Claims

1. A component mounting machine for mounting a circuit component on a mounting surface of a three-dimensional board formed in a three-dimensional shape, the component mounting machine comprising:
a transfer material supply unit configured to supply a transfer material on a transfer table and spread the transfer material in a film shape on the transfer table;
a transfer pin for transferring the transfer material on the transfer table to the mounting surface of the three-dimensional board;
a moving device configured to move the transfer pin; and
a control device configured to control an operation of the moving device, wherein
the control device controls the operation of the moving device to control an operation of immersing a lower end of the transfer pin in the transfer material on the transfer table, attaching the transfer material to the lower end of the transfer pin, and transferring the transfer material to the mounting surface of the three-dimensional board.

2. The component mounting machine according to claim 1, wherein
multiple transfer material supply units for supplying multiple types of transfer materials to the transfer table individually for each type of the transfer materials, and multiple transfer pins are provided, and
the multiple types of transfer materials are individually transferred to the mounting surface of the three-dimensional board by selectively using the multiple transfer pins for each type of the transfer materials.

3. The component mounting machine according to claim 2, wherein
the multiple types of transfer materials are a flowable solder and an adhesive.

4. The component mounting machine according to any one of claims 1 to 3, wherein
the transfer material supply unit is detachably set in a free space of a feeder setting section configured to set a feeder for supplying the circuit component.

5. The component mounting machine according to any one of claims 1 to 4, further comprising:
multiple mounting heads configured to mount the circuit component on the mounting surface of the three-dimensional board, wherein
the transfer pin is held by at least one mounting head of the multiple mounting heads to be exchangeable with a suction nozzle configured to pick up the circuit component.

6. The component mounting machine according to any one of claims 1 to 5, wherein
the three-dimensional board is formed in a shape in which the mounting surface of the three-dimensional board is inclined with respect to a horizontal plane, and
the component mounting machine includes a board tilting device configured to tilt the three-dimensional board until the mounting surface of the three-dimensional board is horizontal and hold the three-dimensional board during a transfer material transfer operation and a component mounting operation.

7. The component mounting machine according to any one of claims 1 to 6, further comprising:
a transfer pin storage section configured to store a transfer pin for exchange, wherein
the transfer pin used for a transfer material transfer operation is automatically exchangeable.

8. A transfer material transfer method for transferring a transfer material to a mounting surface of a three-dimensional board formed in a three-dimensional shape by using a component mounting machine configured to mount a circuit component on the mounting surface of the three-dimensional board, the component mounting machine including multiple mounting heads configured to mount the circuit component on the mounting surface of the three-dimensional board, the method comprising:
setting a transfer material supply unit in a free space of a feeder setting section of the component mounting machine, the transfer material supply unit being configured to supply the transfer material on a transfer table and spread the transfer material in a film shape on the transfer table;
holding a transfer pin by at least one mounting head of the multiple mounting head to be exchangeable with a suction nozzle configured to pick up the circuit component, the transfer pin being for transferring the transfer material on the transfer table to the mounting surface of the three-dimensional board; and
immersing a lower end of the transfer pin in the transfer material on the transfer table to attach the transfer material to the lower end of the transfer pin by moving the mounting head holding the transfer pin to a position above the transfer table to lower and raise the transfer pin, and then transferring the transfer material attached to the lower end of the transfer pin to the mounting surface of the three-dimensional board by moving the mounting head above the mounting surface of the three-dimensional board to lower and raise the transfer pin.

9. The transfer material transfer method according to claim 8, wherein
multiple transfer material supply units for supplying multiple types of transfer materials to the transfer table individually for each type of the transfer materials are set in a free space of the feeder setting section of the component mounting machine,
multiple transfer pins are held by the mounting head to be exchangeable with the suction nozzle, and
the multiple types of transfer materials are individually transferred to the mounting surface of the three-dimensional board by selectively using the multiple transfer pins for each type of the transfer materials.
